(19) Europäisches Patentamt
European Patent Office
Office européen des brevets

(11) Publication number: 0 200 141 A2

# (12) EUROPEAN PATENT APPLICATION

(21) Application number: 86105533.3

(22) Date of filing: 22.04.86

(51) Int. Cl.4: G03F 7/02

(30) Priority: 26.04.85 JP 88998/85

(43) Date of publication of application: 10.12.86 Bulletin 86/45

(84) Designated Contracting States: DE FR GB

(71) Applicant: NIPPON ZEON CO., LTD.
6-1, 2-chome
Marunouchi Chiyoda-ku, Tokyo(JP)
Applicant: FUJITSU LIMITED
1015, Kamikodanaka Nakahara-ku
Kawasaki-shi Kanagawa 211(JP)

(72) Inventor: Oie, Masayuki
Gijutsukaihatsu Cent. of Nippon Zeon
2-1, Yako 1-ch. Kawasaki-ku
Kanagawa-ken(JP)
Inventor: Ogawa, Satoshi
Gijutsukaihatsu Cent. of Nippon Zeon
2-1, Yako 1-ch. Kawasaki-ku
Kanagawa-ken(JP)
Inventor: Sugimoto, Sadao
Gijutsukaihatsu Cent. of Nippon Zeon
2-1, Yako 1-ch. Kawasaki-ku
Kanagawa-ken(JP)
Inventor: Yamazaki, Katsuhiro
Gijutsukaihatsu Cent. of Nippon Zeon
2-1, Yako 1-ch. Kawasaki-ku
Kanagawa-ken(JP)
Inventor: Fujino, Katsuhiro
c/o Fujitsu Limited 1015, Kamikodanaka
Nakahara-ku Kawasaki-shi
Kanagawa-ken(JP)

(74) Representative: Kraus, Walter, Dr. et al
Patentanwälte Kraus, Weisert & Partner
Thomas-Wimmer-Ring 15
D-8000 München 22(DE)

## (54) Photoresist composition.

(57) A Photoresist composition consisting essentially of a conjugated diene polymer or its cyclized product, an organic solvent, a photocross-linking agent and a silylating agent.

EP 0 200 141 A2

Rank Xerox

# PHOTORESIST COMPOSITION

This invention relates to a photoresist composition. More specifically, this invention relates to a photoresist composition that gives a photoresist pattern having an improved adhesion to its substrate.

In recent years, with a marked advance in the technology of producing integrated circuits of semiconductors such as the IC and LSI circuits, there is a strong demand that improvements be made in not only the production techniques but also the apparatuses and fringe or related materials used in their production. In the photoresist art also, there is a demand for photoresist compositions having superior manageability as well as a high resolving power. That which is presently used in the art as a negative-type photoresist composition is one consisting of a cyclized product of a conjugated diene polymer and a diazide. Recently, with the photoresist patterns becoming finer and an increase in the etching speed, there is an increasing demand that the photoresist composition be one in which the photoresist patterns formed therefrom have especially good adhesion to the substrate.

Numerous attempts have been made heretofore for improving the adhesion of the photoresist patterns formed on substrates such as of metals, metal oxides or other compounds. For example, there is disclosed in Japanese Patent Publication No. 25,915/1972 a method of improving the adhesion between the substrate and the photoresist pattern by using a specific compound and treating the surface of the substrate with this compound prior to the application of the photoresist composition, i.e., by activating the substrate surface.

A method such as described is however intended for use with a surface of a specific substrate and cannot be applied universally to the usual substrates. Again, there is the need for a step for treating the substrate surface prior to coating the photoresist composition, thus making the process for producing the LSI circuits complicated. There is hence required a simpler and economical means of improving the adhesion of the photoresist pattern to the substrate.

An object of this invention is to provide a new means by which the aforesaid requirements can be satisfied.

The present inventors found that the aforesaid object can be achieved by using a photoresist composition containing a silylating agent.

There is thus provided in accordance with the present invention a photoresist composition that consists essentially of a conjugated diene polymer or its cyclized product, an organic solvent, a photocross-linking agent and a silylating agent.

The silylating agent used in this invention is imposed no particular restriction so long as it is one having compatibility with the other components of the photoresist composition of this invention. Typical examples of the silylating agent are those compounds having the general formula

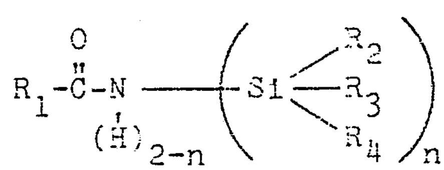

(I)

wherein $R_1$ is an alkyl group or substituted alkyl group of 1 to 5 carbon atoms, $R_2$, $R_3$ and $R_4$ are each an alkyl group or substituted alkyl group of 1 to 7 carbon atoms, and n is an integer from 1 to 2; the compounds of the general formula

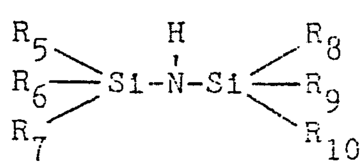

(II)

wherein $R_5$, $R_6$, $R_7$ $R_8$, $R_9$ and $R_{10}$ are each an alkyl group or a substituted alkyl group of 1 to 7 carbon atoms; the compounds of the general formula

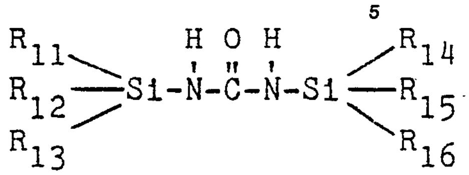

(III)

wherein $R_{11}$, $R_{12}$, $R_{13}$, $R_{14}$, $R_{15}$ and $R_{16}$ are each an alkyl group or a substitued alkyl group of 1 to 7 carbon atoms; and the compounds of the general formula

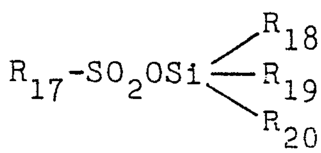

(IV)

wherein $R_{17}$, $R_{18}$, $R_{19}$ and $R_{20}$ are each an alkyl group or a substituted alkyl group of 1 to 7 carbon atoms.

Of these compounds the compounds of the general formula (I) or general formula (II) are preferably used.

The compounds of general formula (I) include, for example, such compounds as N-trimethylsilylacetamide, N-triethylsilylacetamide, N-tripropylsilylacetamide, N,N-bis(trimethylsilyl)acetamide, N,N-bis(trimethylsilyl)trifluoroacetamide and N,N-bis(triethylsilyl)acetamide.

Examples of the compounds of general formula (II) are 1,1,1,3,3,3-hexamethyldisilazane, 1,1,1,3,3,3-hexaethyldisilazane, 1,1,1,3,3,3-hexatrifluoromethyldisilazane and 1,1,1-triethyl-3,3,3-trimethyldisilazane.

The compounds of general formula (III) include, for example, N,N'-bis(trimethylsilyl)urea and N,N'bis(triethylsilyl)urea.

On the other hand, as the compounds of general formula (IV), there can be mentioned such compounds as trimethylsilylmethanesulfonic acid, triethylsilylmethanesulfonic acid and trimethylsilyltrifluoromethanesulfonic acid.

The silylating agent is added in an amount of usually 0.5 to 10 parts by weight, preferably 1 to 5 parts by weight, per 100 parts by weight of the conjugated diene polymer or its cyclized product. When the amount is added is less than 0.5 part by weight, the effect of improving the adhesion is inadequate, whereas when 10 parts by weight is exceeded, this also is undesirable because of an increase in the formation of pinholes.

The conjugated diene polymer or its cyclized product used in this invention is chosen from the homopolymers of the conjugated dienes, copolymers of the conjugated dienes with other copolymerizable monomers, and the cyclized products of these polymers. As typical examples, included are natural rubber, polyisoprene, isoprene/styrene copolymers, polybutadiene, and the cyclized products of these compounds.

The weight average molecular weight of the conjugated diene polymer or its cyclized product usually ranges from 10,000 to 500,000.

As typical examples of the organic solvents usable in this invention, included are the aromatic hydrocarbons such as benzene, toluene and xylene; halogentated hydrocarbons such as trichloroethylene, perchloroethylene, carbon tetrachloride, chlorobenzene and dichlorobenzene; and oxygen-containing hydrocarbons such as tetrahydrofuran and cyclohexanone.

The proportion in which the conjugated diene polymer or its cyclized product is used relative to the organic solvent is suitably determined in accordance with the film thickness required. The former is usually used in an amount of 5 to 30% by weight

to 95 to 70% by weight of the latter. Stated otherwise, the conjugated diene polymer or its cyclized product is used as a solution in the organic solvent in a concentration of 5 to 30% by weight.

As the photocross-linking agent to be used in this invention, usually used are the azides that are soluble in the organic solvents, such as 4,4'-diazidostilbene, p-phenylenebisazide, 4,4'-diazidobenzophenone, 4,4'-diazidochalcon, 2,6-bis(4'-azidobenzal)-cyclohexanone, 2,6-bis(4'-azidobenzal)-4-methylcyclohexanone and 4,4'-diazidodiphenyl. These photocross-linking agents are usually used in an amount of 0.5 to 10 parts by weight per 100 parts by weight of the conjugated diene polymer or its cyclized product.

In addition to the components described hereinabove, the photoresist composition may also contain a stabilizer, as required.

The formation of a photoresist pattern using the photoresist composition of this invention is performed in customary manner. Specifically, the photoresist pattern is formed by proceeding through the steps of coating a substrate with the photoresist composition, followed by exposing the desired pattern through a mask, after which the development, rinsing and etching are performed.

The use of the invention photoresist composition, as compared with the prior art, makes it possible to improve the adhesion between the photoresist pattern and such substrates as those of silicon oxide, phosphorus-silicon glass, aluminum, etc. It thus becomes possible to prevent the separation of the resist pattern at the time of development and etching, with the consequence that the yield of the substrate can be improved.

The following examples will serve to illustrate the present invention more specifically. In the examples and comparative examples the parts and percentages are on a weight basis unless otherwise indicated.

EXAMPLE 1

Twelve grams of a cyclized product of 1,4-polyisoprene obtained by using a lithium catalyst - (weight average molecular weight = 150,000; uncyclized isoprene content 25%) was dissolved in 88g of xylene. To the resulting solution were added 0.36g of 2,6-bis(4'-azidobenzal)-4-methylcyclohexanone as the photocross-linking agent, 0.12g of 2,2'-methylenebis(4-methyl-6-t-butyl)phenol as the stabilizer, and N-trimethylsilylacetamide in a prescribed amount as the silylating agent to prepare a photoresist composition. The thus obtained composition was applied to a substrate having a silicon oxide film coating followed by heating the coated substrate at a temperature of 85°C for 20 minutes to form on the substrate a prebaked film of the photoresist having a thickness of 1 micron. The prebaked photoresist film was then exposed for a prescribed period of time through a photomask having a test pattern formed thereon, using an exposing apparatus equipped with a 200-W high pressure mercury lamp (Model PLA-501F manufactured by Canon Company). This was followed by developing the exposed photoresist film by immersing it in a n-heptane-type developer for one minute, after which it was rinsed for one minute and then etched to give the intended photoresist pattern. The etching was carried out at 25°C for 15 minutes using an etchant having the composition of HF (49% aqueous solution)/$NH_4F$ (40% aqueous solution)/water = 1/6/10 (volume ratio). The amount of the side etch (the phenomenon in which the wafer below the photoresist pattern becomes etched as a result of the etchant making an intrusion thereto) occurring at this time was measured. The results obtained are shown in Table 1.

Table 1

| Run No. | Amount added of N-trimethylsilylacetamide (parts) | Amount of side etch (μm) |
|---|---|---|
| 1 (According to present invention) | 0.5 | 1.2 |
| 2 (ditto) | 3 | 1.0 |
| 3 (ditto) | 5 | 1.0 |
| 4 (Comparison) | 0 | 5.2 |

It can be appreciated from the results given in Table 1 that the amount of side etch in the case of the photoresist pattern of this invention was much less than in the case where the silylating agent was not added, and hence that the adhesion to the substrate was satisfactory.

EXAMPLE 2

The experiment was carried out as in Example 1 but adding severally 3 parts by weight of the compounds shown in Table 2 as compounds of this invention.

The results obtained are shown in Table 3.

Table 2

| No. | Name of substance |
|---|---|
| A | N,N-bis(trimethylsilyl)acetamide |
| B | 1,1,1,3,3,3-hexamethyldisilazane |
| C | 1,1,1,3,3,3-hexatrifluoromethyldisilazane |
| D | N,N'-bis(trimethylsilyl)urea |
| E | Trimethylsilyltrifluoromethanesulfonic acid |

Table 3

| Run No. | Substance | Amount of side etch (um) |
|---|---|---|
| 1 (According to this invention) | A | 0.8 |
| 2 (ditto) | B | 1.4 |
| 3 (ditto) | C | 1.3 |
| 4 (ditto) | D | 1.0 |
| 5 (ditto) | E | 1.0 |
| 6 (Comparison) | Not added | 5.2 |

It can be seen from the results given in Table 3 that the amount of side etch was much less than in the case where the silylating agent was not added, and hence that the adhesion to the substrate was satisfactory.

**Claims**

1. A photoresist composition consisting essentially of a conjugated diene polymer or its cyclized product, an organic solvent, a photocross-linking agent and a silylating agent.

2. A composition of claim 1 wherein the conjugated diene polymer or its cyclized product is selected from the group consisting of natural rubber, polyisoprene, isoprene/styrene copolymers, polybutadiene and cyclized products of these substances.

3. A composition of claim 1 wherein said photocross-linking agent is an azide-type compound.

4. A composition of claim 1 wherein the photocross-linking agent is contained in an amount of 0.5 to 10 parts by weight per 100 parts by weight of the conjugated diene polymer or its cyclized product.

5. A composition of claim 1 wherein said silylating agent is a member selected from the group consisting of the compounds having the general formula

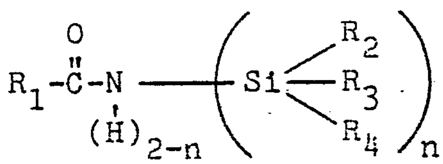

(I)

wherein $R_1$ is a member chosen from the class consisting of the alkyl and substituted alkyl groups having 1 to 5 carbon atoms, $R_2$, $R_3$ and $R_4$ are each a member chosen from the class consisting of the alkyl and substituted alkyl groups having 1 to 7 carbon atoms, and n is an integer from 1 to 2; the compounds having the general formula

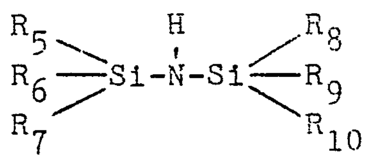

(II)

wherein $R_5$, $R_6$ $R_7$, $R_8$, $R_9$ and $R_{10}$ are each a member chosen from the class consisting of the alkyl and substituted alkyl groups having 1 to 7 carbon atoms; the compounds having the general formula

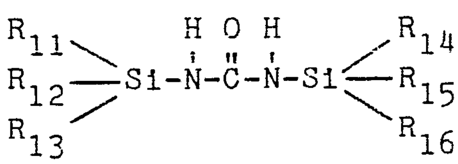

(III)

wherein $R_{11}$, $R_{12}$, $R_{13}$, $R_{14}$, $R_{15}$ and $R_{16}$ are each a member chosen from the class consisting of the alkyl and substituted alkyl groups having 1 to 7 carbon atoms; and the compounds having the general formula

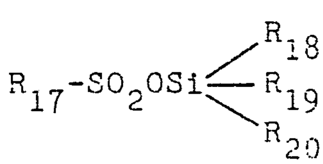

(IV)

wherein $R_{17}$, $R_{18}$, $R_{19}$ and $R_{20}$ are each a member chosen from the class consisting of the alkyl and substituted alkyl groups having 1 to 7 carbon atoms.

6. A composition of claim 1 wherein said silylating agent is contained in an amount of 0.5 to 10 parts by weight per 100 parts of the conjugated diene polymer or its cyclized product.

7. A composition of claim 1 wherein the relative proportion of the conjugated diene polymer or its

cyclized product to the organic solvent is 5 to 30% by weight of the former to 95 to 70% by weight of the latter.